# EUROPÄISCHE PATENTSCHRIFT

(11) **EP 4 478 429 B1**
(45) Veröffentlichungstag und Bekanntmachung des Hinweises auf die Patenterteilung: **07.05.2025**
(21) Anmeldenummer: 24000069.5
(22) Anmeldetag: 07.06.2024
(51) Int. Cl.: H10F 10/142, H10F 10/144, H10F 71/00, H01L 21/78

(54) **VERFAHREN ZUR HERSTELLUNG EINES GRABENS BEI EINER III-V MEHRFACHSOLARZELLE**
METHOD OF FORMING A TRENCH IN A III-V MULTI-JUNCTION SOLAR CELL
PROCÉDÉ DE RÉALISATION D'UNE TRANCHÉE DANS UNE CELLULE SOLAIRE MULTIPLE III-V

(30) Priorität: 14.06.2023 DE 102023002414
(43) Veröffentlichungstag der Anmeldung: 18.12.2024
(73) Patentinhaber: AZUR SPACE Solar Power GmbH, 74072 Heilbronn (DE)
(72) Erfinder: Sommer, Steffen, 71732 Tamm (DE); Köstler, Wolfgang, 74074 Heilbronn (DE)
(74) Vertreter: Koch Müller Patentanwaltsgesellschaft mbH

(56) Entgegenhaltungen:
- EP-A1- 3 787 044
- EP-A2- 2 413 372
- WO-A1-2010/042981
- CN-A- 104 868 017
- DE-A1- 102019 006 094
- DE-A1- 102019 008 106
- DE-A1- 102021 121 684
- US-A1- 2013 237 035
- US-A1- 2015 279 728
- US-A1- 2020 312 715

## Beschreibung

Aus der DE 692 16 502 T2 ist ein Laserschneidverfahren zur Herstellung von Durchgangslöchern für Durchkontaktierungen bei GaAs bzw. Ge- Solarzellen bekannt, wobei mit dem offenbarten Verfahren u.a. Nachteile einer CVD SiO₂ Beschichtung bei Durchgangslöchern vermieden werden sollen.

In einem ersten Verfahrensschritt wird mittels von Laserpulsen eines Festkörper- Lasers eine durchgehende Öffnung mit einem großen Durchmesser erzeugt. Um die bei dem Laserbeschuss entstehenden sehr rauen Oberflächen an den Seitenwänden der Durchgangsöffnung für eine spätere Metallisierung vorzubereiten, werden in einem zweiten Verfahrensschritt u.a. die Seitenwände mit einem Polyimid übergossen bzw. bei kleineren durchgehenden Öffnungen die Öffnung vollständig mit Polyimid gefüllt.

In einem nachfolgenden Verfahrensschritt wird das Polyimid zum Aushärten erwärmt. Das Polyimid wird als dielektrische Beschichtung bezeichnet.

In einem vierten Verfahrensschritt wird mittels des Lasers innerhalb des Po-Iyimid ein Durchgangsloch mit einem kleinen Durchmesser erzeugt, wobei das Polyimid nach dem Laserbeschuss an den neu entstehenden Seitenflächen glatte Oberfläche aufweist. Die Polyimid Seitenflächen werden in einem nachfolgenden Verfahrensschritt mit einem Metall bedeckt.

Mit der Auftragung von Polyimid wird u.a. auch die Notwendigkeit, mittels einer aggressiven chemischen Ätzung die Seitenflächen zu glätten, vermieden und der aktive Bereich der Solarzelle und das GaAs-Substrat oder das Ge-Substrat vor dem Ätzangriff geschützt. Ferner weist das Polyimid eine gute Haftung sowohl zu dem Substrat als auch gegenüber einer aufzubringenden Durchführungsmetallisierung auf.

Aus der WO 2010/042981 A1 ist auch ein Laserschneidverfahren zur Herstellung von III-V-Mehrfachsolarzellen bekannt, bei dem durchgehende Gräben durch die Kombination eines Laserverfahrens mit einem Fotolithografieverfahren hergestellt werden.

Vor diesem Hintergrund besteht die Aufgabe der Erfindung darin, ein Verfahren anzugeben mit dem der Stand der Technik weitergebildet wird.

Die Aufgabe wird durch ein Verfahren zur Herstellung eines Grabens bei einer III-V Mehrfachsolarzelle mit den Merkmalen des Patentanspruchs 1 gelöst. Vorteilhafte Ausgestaltungen der Erfindung sind Gegenstand von Unteransprüchen.

Gemäß dem Gegenstand wird ein Verfahren zur Herstellung eines Grabens bei einer III-V Mehrfachsolarzelle bereitgestellt.

Die III-V Mehrfachsolarzelle weist eine Oberseite und eine Unterseite auf und umfasst ein an der Unterseite angeordnetes Substrat.

Das Substrat ist als Halbleiterscheibe ausgebildet und weist auf einer Vorderseite ein Epi-Schichtsystem mit mehreren III-V Schichten auf.

Das Epi-Schichtsystem umfasst wenigstens eine an der Oberseite der III-V Mehrfachsolarzelle ausgebildete erste III-V Solarzelle, wobei auf der ersten III-V Solarzelle eine organische Schicht angeordnet ist.

In einem ersten Verfahrensschritt wird mittels eines Lasers ein erster Graben mit einer Breite X und mit einer in dem Epi-Schichtsystem ausgebildeten Bodenfläche erzeugt.

In einem zweiten Verfahrensschritt wird mittels des Lasers in der Bodenfläche des ersten Grabens ein zweiter Graben mit einer Breite Y und mit einer in dem Substrat ausgebildeten Bodenfläche erzeugt, wobei die Breite Y kleiner als die Breite X ist, so dass sich mit der Ausführung des zweiten Verfahrensschritts eine erste Stufe ausbildet,
die vorgenannten Verfahrensschritte werden in der angegebenen Reihenfolge ausgeführt oder in einer Alternative wird der zweite Verfahrensschritt vor dem ersten Verfahrensschritt ausgeführt, wobei der zweite Graben (GA2) bei der alternativen Durchführung vor dem ersten Graben (GA1) erzeugt wird.

Es sei angemerkt, dass die organische Schicht eine Lackschicht und / oder eine Polyimid Schicht und / oder eine Kunststoffschicht umfasst. Es versteht sich, dass die Schichten unstrukturiert ausgebildet sind, um insbesondere einen Maskenschritt d.h. Lithographieschritt zu vermeiden.

Des Weiteren versteht es sich, dass es sich bei dem Substrat um ein Halbleitersubstrat mit einem Durchmesser von wenigstens oder genau 100 mm oder wenigstens oder genau 150 mm handelt.

Es sei angemerkt, dass vorliegend unter dem Begriff der dielektrischen Schicht ausschließlich anorganische Schichten, insbesondere Oxid und Nitridschichten, umfasst sind.

Des Weiteren sei angemerkt, dass mit dem Begriff "Graben" eine länglich ausgebildete Vertiefung mit einer Länge von wenigstens 100 µm oder wenigstens 200 µm bezeichnet wird.

Es versteht sich, dass unter dem Begriff "Epi-Schichtsystem" ausschließlich die auf dem Substrat mittels eines Epitaxie-Prozesses hergestellte III-V Schichten bezeichnet werden.

Des Weiteren sei angemerkt, dass die bei allen laserbasierten Verfahrensschritte jeweils entstehenden Seitenflächen genau senkrecht oder nahezu senkrecht ausgebildet sind, wobei unter dem Begriff "nahezu senkrecht" eine Abweichung kleiner als 5° verstanden wird.

In einer Weiterbildung ist der Öffnungswinkel weniger als 20° oder weniger als 10°. Unter dem Öffnungswinkel wird hierbei der Winkel verstanden der gegen die Senkrechte geneigt ist, wobei die Neigung nach "außen" erfolgt, sodass der Gesamtwinkel mehr als 90° beträgt. Anders ausgedrückt, der Graben weist an der Oberseite, bei einer nicht senkrechten Ausführung einen größeren Durchmesser als im Bereich des Bodens auf ist also konisch ausgebildet, der Graben weist in einem Querschnitt eine konisch ausgebildete Form auf.

Ein Vorteil ist, dass sich mit dem Verfahren ohne weitere Strukturierung mittels aufwändigen und teuren Llthographieprozessen die organischen Schichten, insbesondere Lackschichten, flexibel an beliebigen Stellen auf der Oberseite der III-V Mehrfachsolarzelle durchgehende Graben anordnen lassen.

Ein weiterer Vorteil ist, dass das wenigstens zweistufige Laser-Verfahren überraschenderweise unempfindlich gegen eine nicht wesentliche Veränderung des Schichtbaus, insbesondere der Dicke und der Anzahl der III-V Schichten ist. Auch ist das Verfahren unempfindlich gegen die Änderung des Substratmaterials von Ge nach GaAs und vice versa.

Nicht wesentliche Änderungen sind insbesondere eine Änderung der III-V Materialzusammensetzung und der Stöchiometrie und eine Veränderung der Gesamtschichtdicke um weniger als 20 µm.

Ein anderer Vorteil ist, dass auch bei einer wesentlichen Änderung der Substratdicke sich die Einstellung des Lasers bei laserbasierten Verfahrensschritten-leicht abändern lassen.

Vorliegend wird als wesentliche Änderung eine Änderung der Dicke des Substrats um mindestens 50 µm oder um mindestens 100 µm bezeichnet.

Ein anderer Vorteil von laserbasierten Verfahrensschritten im Vergleich zu nasschemischen Verfahrensschritten ist, dass keine Unterätzung auftritt. Des Weiteren bedingen nasschemische Verfahrensschritte grundsätzlich ein strukturiertes Aufbringen von Schutzlacken auf der Oberfläche und / oder auf Seitenflächen von grabenförmigen Strukturen, insbesondere dann, wenn die grabenförmige Struktur wenigstens eine Stufe umfasst.

In einer Ausführungsform wird in einem dritten Verfahrensschritt entlang der grabenförmigen Struktur ausgehend von der Oberseite oder ausgehend von der Unterseite mittels eines Trennprozesses ein Schlitz in den Boden des zweiten Grabens erzeugt wird, um das Substrat zu zerteilen. In einer Weiterbildung weist der Schlitz wenigstens eine Länge von 50 µm auf. Es versteht sich hierbei, dass die beiden Verfahrensschritte, d.h. der erste Verfahrensschritt und der zweite Verfahrensschritt bereits ausgeführt sind.

In einer anderen Ausführungsform wird der Schlitz durchgehend entlang einer Geraden ausgebildet und mit einer Breite Z erzeugt, wobei die Breite Z in einem Bereich zwischen 5 µm und 120 µm oder zwischen 10 µm und 80 µm liegt.

In einer Weiterbildung wird in dem dritten Verfahrensschritt das Substrat mittels einer Säge ausgehend von der Unterseite der III-V Mehrfachsolarzelle bzw. von der Unterseite des Substrats zerteilt.

In einer anderen Weiterbildung wird der dritte Verfahrensschritt für die Erzeugung des Schlitzes unter Verwendung des Lasers ausgehend von der Oberseite der III-V Mehrfachsolarzelle durchgeführt. Hierbei versteht es sich, dass der laserbasierte Verfahrensschritt vorzugsweise unmittelbar nach den beiden anderen laserbasierten Verfahrensschritten durchgeführt wird.

Anders ausgedrückt, der dritte Verfahrensschritt wird entweder mittels eines Laserprozesses ausgehend von der Oberseite durchgeführt oder alternativ ausgehend von der Unterseite des Substrats mittels einer Säge. Die bei der Ausführung des dritten Verfahrensschritts entstehenden weiteren Seitenflächen bei den Schlitzen sind ebenfalls nahezu senkrecht oder genau senkrecht ausgebildet.

Des Weiteren sei angemerkt, dass die in dem Epi-Schichtsystem in dem ersten Graben ausgebildete Bodenfläche ein zweiter Graben umfasst, wobei die Bodenfläche des zweiten Grabens in dem Substrat ausgebildet ist. Entsprechend ist die Bodenfläche des ersten Grabens durch den zweiten Graben in zwei Teile geteilt, wobei die beiden Teile der Bodenfläche des ersten Grabens jeweils entlang der Seitenflächen aus III-V Material verlaufen.

Sofern der zweite Graben einen bis hin zu der Unterseite des Substrats reichenden Schlitz umfasst, ist auch die Bodenfläche des zweiten Grabens in zwei Teile geteilt, nämlich durch den Schlitz, wobei die beiden Teile der Bodenfläche des zweiten Grabens jeweils entlang der aus dem Material des Substrats gebildeten Seitenflächen verlaufen.

Es versteht sich, dass die in den Bodenbereichen ausgebildeten Flächen plan sind oder in einer ersten Näherung plan sind oder Unebenheiten aufweisen und die Fläche am Boden bei dem Epi-Schichtsystem ausschließlich aus einem III-V Material oder bei der Bodenfläche in dem Substrat ausschließliche aus dem Substratmaterial bestehen.

Sofern die Verfahrensschritte nicht in der angegebenen Reihenfolge ausgeführt werden, wird in einer Weiterbildung der zweite Verfahrensschritt als erstes ausgeführt und anschließend entweder der erste Verfahrensschritt oder der dritte Verfahrensschritt ausgeführt. Hiernach anschließend wird der noch nicht ausgeführte Verfahrensschritt d.h. der dritte Verfahrensschritt oder der erste Verfahrensschritt ausgeführt.

Es versteht sich, dass nach der Durchführung aller drei Verfahrensschritte, unabhängig von der Reihenfolge deren Ausführung, immer zumindest eine erste Stufe ausgebildet ist oder im Falle der Ausbildung des Schlitzes zwei Stufen ausgebildet sind.

Anders ausgedrückt, auch wenn die Verfahrensschritte in unterschiedliche Reihenfolge durchgeführt werden oder der dritte Verfahrensschritt auf verschiedene Weise ausgeführt wird, entsprechen sich In einer Querschnittsansicht die entstandenen Stufenformen einander oder sind insbesondere genau gleich ausgebildet.

In einer Ausführungsform werden die ersten beiden Verfahrensschritte, d.h. der erste Verfahrensschritt und der zweite Verfahrensschritt ohne Zwischenschritte, wie Nassätzschritte oder Trockenätzschritte nacheinander ausgeführt.

In einer anderen Ausführungsform wird der dritte Laser-Verfahrensschritt oder werden alle laserbasierten Verfahrensschritte ohne Zwischenschritte, insbesondere wie Nassätzschritte oder Trockenätzschritte nacheinander ausgeführt.

In einer Weiterbildung werden anstelle von den drei aufeinanderfolgenden Laserverfahrensschritten auch mehr als drei beispielsweise vier oder fünf Verfahrensschritte unter Verwendung des Lasers durchgeführt.

In einer Weiterbildung ist zwischen dem Substrat und der ersten III-V Solarzelle wenigstens eine weitere III-V Solarzelle ausgebildet.

In einer Ausführungsform weist die erste III-V Solarzelle als oberste III-V Solarzelle eine größere Bandlücke oder eine gleich große Bandlücke auf wie die darunterliegenden III-V Solarzellen.

Um die stapelförmig angeordneten III-V Solarzellen elektrisch miteinander in Serie zu verschalten sind zwischen den beiden III-V Solarzellen mehrere Tunneldiodenschichten angeordnet.

In einer anderen Weiterbildung weisen die beiden III-V Solarzellen gleiche oder unterschiedliche Materialien auf. In einer Ausführungsform umfasst die oberste III-V Solarzelle eine InGaP Verbindung. In einer Weiterbildung ist die weitere III-V Solarzelle als zweite III-V Solarzelle ausgebildet und umfasst eine GaAs Verbindung oder einer InGaAs Verbindung.

In einer Ausführungsform umfasst das Substrat Ge oder GaAs oder besteht aus Ge oder GaAs. Es versteht sich, dass auf dem Substrat eine Vielzahl von III-V Schichten angeordnet werden. Vorzugsweise werden die Schichten mittels einer MOVPE Anlage epitaktisch aufgewachsen.

In einer anderen Ausführungsform ist in der Oberseite des Substrats oder an der Oberseite des Substrats eine Substratsolarzelle ausgebildet. Im Fall des GaAs Substrat ist die Substratsolarzelle eine III-V Solarzelle im Fall von Ge eine VI - Solarzelle.

Es sei angemerkt, dass bei der Ausbildung des Substrats als Ge-Substrat, das Ge- Substrat meist als p-Ge-Substrat ausgebildet ist und im Fall der Ausbildung einer n-Ge-Schicht für die Ausbildung der Gruppe VI-Solarzelle an der Oberfläche oder in der Oberfläche des p-Ge-Substrats die n-Schicht mittels Eindiffusion von Dotanten und nicht mittels einer Epitaxie erzeugt wird.

In einer Weiterbildung weist das Substrat eine Dicke in einem Bereich zwischen 40 µm um 850 µm auf. In einer anderen Weiterbildung liegt die Dicke des Substrats in einem Bereich zwischen 150 µm und 750 µm.

In einer Ausführungsform sind oberhalb der ersten III-V Solarzelle und unterhalb der organischen Schicht weitere Schichten ausgebildet, wobei die weiteren Schichten als organische und / oder als anorganische Schichten ausgebildet sind. Vorzugsweise umfassen oder bestehen die weiteren Schichten Passivierungsschichten beispielsweise wenigstens eine III-V Schicht und / oder wenigstens eine Siliziumoxid- und / oder wenigstens eine SIIIziumnitrid-Schicht.

In einer anderen Weiterbildung ist zwischen der ersten III-V Solarzelle und der organischen Schicht eine Antireflexschicht ausgebildet.

In einer anderen Ausführungsform ist die organische Schicht als durchgehende, die gesamte Oberseite der ersten III-V Solarzelle bedeckende Schicht, d.h. unstrukturiert ausgebildet. Hierbei lässt sich die organische Schicht sowohl durch Aufschleudern oder durch ein anderes Beschichtungsverfahren aufbringen.

In einer Ausführungsform ist auf der Oberseite der III-V Mehrfachsolarzelle in dem Bereich des Grabens zwischen der ersten III-V Solarzelle und der organischen Schicht eine Metallschicht angeordnet oder genau keine Metallschicht ausgebildet. Anders ausgedrückt bei der Ausbildung oder bei der nicht Ausbildung einer Metallschicht an der Stelle des herzustellenden Grabens lässt sich der erste Verfahrensschritt und / oder der zweite Verfahrensschritt durchführen.

In einer Weiterbildung wird in dem Graben in einer Richtung von der Oberseite hin zu der Unterseite der III-V Mehrfachsolarzelle während der Durchführung des Laserprozesses wenigstens eine zweite Stufe ausgebildet.

In einer anderen Weiterbildung wird nach der Durchführung der ersten beiden Verfahrensschritte mit dem Laser eine nasschemische Ätzung, insbesondere zur Reinigung der Oberflächen und der Seitenflächen durchgeführt.

In einer Weiterbildung ist, je nach verwendeter Ätzlösung und deren Anwendungsdauer ist nach der Ätzung nur noch eine von beiden Stufen sichtbar. Vorzugsweise wird der nasschemische Ätzschritt unmittelbar nach der Durchführung des zweiten Laser-Verfahrensschritts bzw. nach der Durchführung des ersten laserbasierten Verfahrensschritts und des zweiten laserbasierten Verfahrensschritts ausgeführt.

In dem Nassätzschritt werden die Breite des ersten Grabens und die Breite des zweiten Grabens jeweils vergrößert und / oder die Tiefe des ersten Grabens und oder des zweiten Grabens vergrößert. In einer Weiterbildung liegt die Vergrößerung des ersten Grabens und oder des zweiten Grabens In einem Bereich zwischen 0,5 µm und 30 µm.

In einer Weiterbildung wird die Entfernung der organischen Schicht erst nach der Ausführung eines nasschemischen Ätzschrittes durchgeführt. Ein Vorteil ist, dass die Oberfläche durch die organische Schicht vor einem Ätzangriff geschützt wird.

In einer Ausführungsform liegt die Breite X des ersten Grabens in einem Bereich zwischen 20 µm und 300 µm. In einer anderen Ausführungsform liegt die Breite Y des zweiten Grabens in einem Bereich zwischen 5 µm und 200 µm. Es versteht sich jedoch, dass die Breite des ersten Grabens immer breiter als die Breite des zweiten Grabens ausgebildet wird. Alternativ liegt das Verhältnis der Breite des ersten Grabens zu der Breite des zweiten Grabens in einem Bereich zwischen 1 und 10.

In einer Weiterbildung wird nach der Ausführung aller laserbasierten Verfahrensschritte ein Nassätzschritt durchgeführt. Ein Vorteil des Nassätzschrittes ist, dass die Oberflächen von Resten der laserbasierten Verfahrensschritte gereinigt werden.

In einer Ausführungsform wird der Nassätzschritt vor dem Sägeschritt ausgeführt.

In einer anderen Ausführungsform wird unmittelbar nach dem zweiten Verfahrensschritt bzw. nach der Durchführung der ersten beiden Verfahrensschritte d.h. vor dem Entfernen der organischen Schicht ein Nassätzschritt durchgeführt. Ein Vorteil ist, dass mittels der organischen Schicht die Oberseite bzw. die Oberfläche der Mehrfachsolarzelle nicht nur vor einer Verunreinigung, bei der Durchführung der laserbasierten Verfahrensschritte, sondern auch vor einem Ätzangriff schützt wird.

In einer anderen Ausführungsform, wird die organische Schicht erst nach der Ausführung aller laserbasierten Verfahrensschritte und des Nassätzschritts entfernt. Es sei angemerkt, dass die organische Schicht vorzugsweise mittels eines nasschemischen oder Trockenätzprozesses entfernt.

In einer Weiterbildung ist das Substrat als Halbleiterscheibe mit einem Durchmesser von wenigstens oder genau 100 mm oder wenigstens oder genau 150 mm ausgebildet.

In einer anderen Weiterbildung wird das Substrat nur entlang des Grabens zertrennt.

In einer Ausführungsform wird in vorgegebenen Bereichen der dritte Verfahrensschritt nicht ausgeführt, so dass der zweite Boden erhalten und das Substrat in den vorgegebenen Bereichen nicht zerteilt wird.

Die Erfindung wird nachfolgend unter Bezugnahme auf die Zeichnungen näher erläutert. Hierbei werden gleichartige Teile mit identischen Bezeichnungen beschriftet. Die dargestellten Ausführungsformen sind stark schematisiert, d.h. die Abstände und die lateralen und die vertikalen Erstreckungen sind nicht maßstäblich und weisen, sofern nicht anders angegeben, auch keine ableitbaren geometrischen Relationen zueinander auf. Darin zeigen, die
- Figur 1a-c: Querschnittsansichten auf eine entstehende Graben-Struktur nach unterschiedlichen Laserverfahrensschritten,
- Figur 2: eine Querschnittsansicht auf die Grabenstruktur der Ausführungsforrn dargestellt in der Fig. 1c nach einem Nassätzschritt und Entlackungsprozess,
- Figur 3: eine Querschnittsansicht auf die Grabenstruktur mit einem Schlitz nach einem dritten laserbasierten Verfahrensschritt,
- Figur 4: eine Querschnittsansicht auf die Grabenstruktur mit einem Schlitz nach einem Sägeschritt,
- Figur 5: eine Draufsicht auf eine Halbleiterscheibe mit Grabenstruktur und Schlitz.

Der nachfolgend dargestellten Querschnitte zeigen jeweils einen Ausschnitt aus einer Mehrfachsolarzellenstruktur MS, wobei die Mehrfachzellenstruktur MS oder eine Vielzahl von Mehrfachzellenstrukturen auf einer Halbleiterscheibe mit wenigstens 100 mm Durchmesser ausgebildet ist bzw. sind.

Die nachfolgenden Abbildungen zeigen außerdem ausschließlich eine Ausführungsform bei der die Verfahrensschritte eins bis drei in der angegebenen Reihenfolge durchgeführt werden, d.h. der erste Verfahrensschritt wird als erstes der zweite Verfahrensschritt als zweitens und sofern der dritte Verfahrensschritt durchgeführt wird, wird der dritte Verfahrensschritt nach dem zweiten Verfahrensschritt ausgeführt.

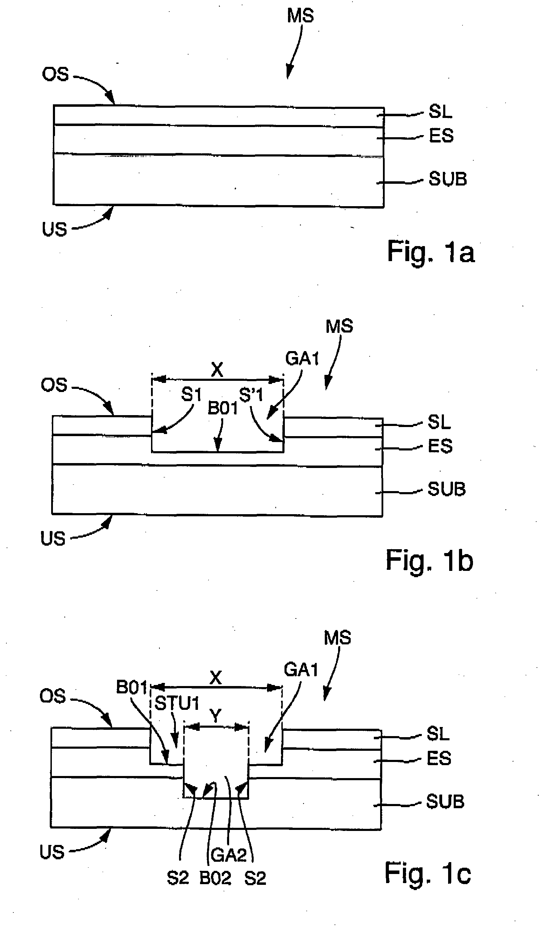

In der Abbildung der Figur 1a bis 1c sind einzelne Querschnittsansichten auf eine entstehende Graben-Struktur dargestellt, wobei die Abbildung der Figur 1b die entstehende Graben-Struktur nach der Durchführung des ersten Laserverfahrensschritts und die Abbildung der Figur 1c die entstehende Graben-Struktur nach der Durchführung des zweiten Laserverfahrensschritts zeigt.

Die Abbildung der Figur 1a zeigt eine Querschnittsansicht auf eine nicht bearbeitete Mehrfachsolarzellenstruktur MS mit einer Unterseite US und einer Oberseite OS. An der Unterseite US der Mehrfachsolarzellenstruktur MS ist eine Substratschicht SUB aus Germanium oder GaAs ausgebildet. Die Substratschicht SUB weist eine Unterseite auf, wobei die Unterseite der Substratschicht SUB an der Unterseite US der Mehrfachzellenstruktur MS ausgebildet ist.

Auf einer Oberseite der Substratschicht SUB ist ein Epischichtsystem ES ausgebildet. Das Epi-Schichtsystem ES ist stoffschlüssig auf der Substratschicht SUB angeordnet. Es versteht sich, dass das Epi-Schichtsystem ES eine Vielzahl von III-V Schichten umfasst.

Das Epi-Schichtsystem ES umfasst wenigstens eine nicht dargestellte erste Solarzelle, wobei die erste Solarzelle immer als oberste Solarzelle ausgebildet ist, auch wenn in weiteren nicht dargestellten Ausführungsformen zwischen der ersten Solarzelle und dem Substrat SUB eine oder mehrere weitere Solarzellen ausgebildet sind.

Auf dem Epi-Schichtsystem ES ist eine als Schutzlack ausgebildete organische Schicht SL angeordnet. Die organische Schicht SL ist in der dargestellten Ausführungsform ganzflächig und stoffschlüssig auf der Halbleiterscheibe mit der Oberseite des III-V Epi-Schichtsystem ES verbunden.

In der einer nicht dargestellten Ausführungsform ist eine weitere Schicht oder sind zwischen dem Epi-Schichtsystem und der organische Schicht SL weitere Schichten, insbesondere Passivierungsschichten stoffschlüssig auf dem Epi-Schichtsystem ES ausgebildet.

In einem ersten Verfahrensschritt, dargestellt in der Fig. 1b, wird mittels eines Lasers ein erster Graben GA1 mit einer Öffnung mit einer Breite X durch die organische Schicht SL mit einer in dem Epi-Schichtsystem ES ausgebildeten ersten Bodenfläche BO1 erzeugt. Die entstehenden Seitenflächen S1 sind nahezu senkrecht ausgebildet.

In einem zweiten Verfahrensschritt, dargestellt in der Fig. 1c, wird mittels des Lasers in der Bodenfläche BO1 des ersten Grabens GA1 eine Öffnung mit einer Breite Y und mit einer in dem Substrat SUB ausgebildeten zweiten Bodenfläche BO2 erzeugt, wobei die Breite Y kleiner als die Breite X ist. Indem nur in einem Teil der ersten Bodenfläche BO1 des Epi-Schichtsystems ein zweiter Graben GA2 erzeugt wird, entsteht eine erste Stufe STU1. Auch die bei dem zweiten Verfahrensschritt entstehende Seitenflächen S2 sind nahezu senkrecht ausgebildet.

Es versteht sich, dass in einer nicht dargestellten Ausführungsform die mittels des Lasers ausgeführten Verfahrensschritte auch in einer anderen Reihenfolge ausgeführt werden. Insbesondere lässt sich der zweite Verfahrensschritt vor dem ersten Verfahrensschritt ausführen.

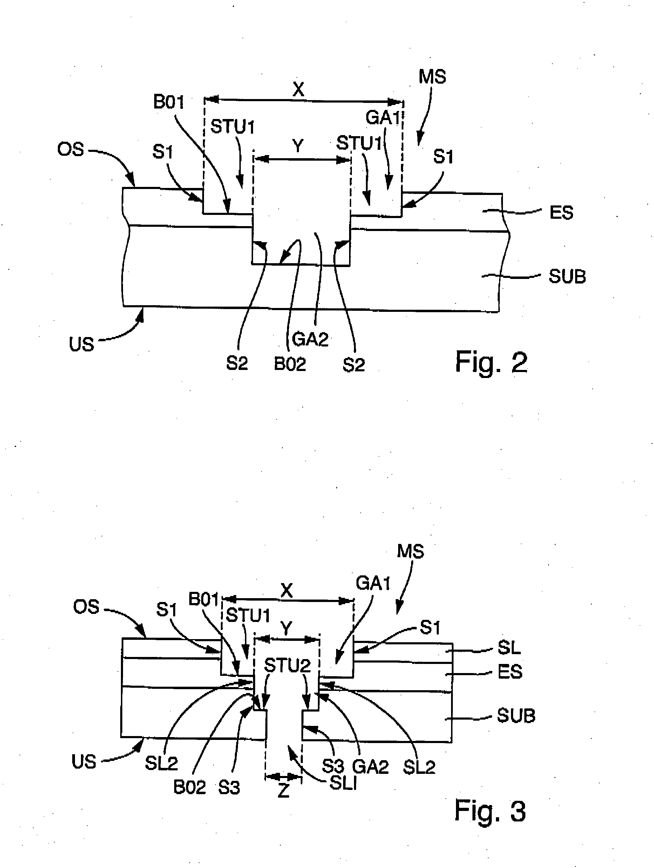

In der Abbildung der Figur 2 ist eine Querschnittsansicht auf die Grabenstruktur der Ausführungsform dargestellt in der Fig. 1c nach einem Nassätzschritt und Entlackungsprozess dargestellt. Im Folgenden werden nur die Unterschiede zu der Abbildung der Figur 1c erläutert.

In einem Nassätzschritt, durchgeführt um die Seitenwände S1, S2 und die erste Stufe STU1 und die zweite Bodenfläche BO2 zu reinigen. Die Seitenflächen S1 und S2 sind zurückverlegt, d.h. die Breite X des ersten Grabens GA1 und die Breite Y des zweiten Grabens sind etwas vergrößert. Auch Tiefe des zweiten Grabens GA2 ist etwas größer, d.h. die zweite Bodenfläche GA2 BO2 ist tiefer in das Substrat SUB hinein verlegt.

Um die Oberseite OS der Mehrfachsolarzelle MS vor dem Ätzangriff zu schützen wird der Schutzlack an der Oberseite OS erst nach dem Nassätzprozess mittels eines Ablackprozesses entfernt.

In der Abbildung der Figur 3 ist eine Querschnittsansicht auf die Grabenstruktur der Ausführungsform, dargestellt in Zusammenhang mit der Abbildung der Fig. 1c, nach einem dritten mittels des Lasers ausgeführten Verfahrensschritt dargestellt. Im Folgenden werden nur die Unterschiede zu der Abbildung der Figur 1c erläutert.

In einem dritten Verfahrensschritt wird mittels des Lasers zur Ausbildung des Schlitzes SLI eine Öffnung mit einer Breite Z erzeugt, wobei die Öffnung indem der Schlitz SLI durchgehend ist, d.h. der Schlitz SLI sich bis zur Unterseite US erstreckt, keine Bodenfläche aufweist und die Breite Z kleiner als die Breite Y ist. Indem nur in einem Teil der zweiten Bodenfläche BO2 des Epi-Schlchtsystems ein Schlitz erzeugt wird, entsteht eine zweite Stufe STU2.

In der Abbildung Figur 4 ist eine Querschnittsansicht auf die Grabenstruktur, dargestellt In Zusammenhang mit der Abbildung der Figur 2, nach einem in dem dritten Verfahrensschritt mittels eines Sägeschritts erzeugten Schlitzes abgebildet. Im Folgenden werden nur die Unterschiede zu der vorangegangenen Ausführungsform, dargestellt in Zusammenhang mit der Abbildung der Fig. 2, dargestellt.

In einem nicht dargestellten Verfahrensschritt wird vor der Durchführung des dritten Verfahrensschritts das Substrat SUB von der Unterseite US gedünnt.

Nach dem Dünnen der Halbleiterscheibe wird von der Unterseite US des Substrats SUB ausgehend In einem Sägeschritt mittels einer Säge ein Schlitz SLI erzeugt, um die auf der Vorderseite ausgebildeten Solarzellenstapel MS aufzuteilen.

Die Abbildung der Figur 5 zeigt eine Draufsicht auf eine Halbleiterscheibe, wobei auf der Halbleiterschreibe sowohl die Grabenstruktur und als auch der Schlitz ausgebildet sind.

Im Folgenden werden nur die Unterschiede zu der vorangegangenen Abbildung der Fig. 2 dargestellt. In der vorliegenden Ausführungsform wird indem dritten Verfahrensschritt entlang der Grabenstruktur ein Schlitz erzeugt. Der Schlitz beginnt und endet immer an dem Rand der Halbleiterscheibe.

Auf der Oberseite OS der Mehrfachsolarzellenstruktur MS sind sowohl Schlitzstrukturen SLI als auch Grabenstrukturen ohne Schlitz dargestellt. Ein Vorteil ist, dass beide Strukturen auf derselben Halbleiterscheibe ausgebildet sind.

Es zeigt sich, dass unterschiedliche Größen von Bauelementen sich auf einer Halbleiterscheibe herstellen lässt.

## Patentansprüche

1. Verfahren zur Herstellung einer grabenförmigen Struktur (GA) bei einer III-V Mehrfachsolarzelle (MS) mit einer Oberseite (OS) und einer Unterseite (US), und die III-V Mehrfachsolarzelle (MS) ein an der Unterseite (US) angeordnetes Substrat (SUB) umfasst, und das Substrat (SUB) als Halbleiterscheibe ausgebildet ist und auf einer Vorderseite ein Epi-Schichtsystem (ES) mit mehreren III-V Schichten aufweist, wobei das Epi-Schichtsystem (ES) wenigstens eine an der Oberseite (OS) der III-V Mehrfachsolarzelle (MS) ausgebildete erste III-V Solarzelle umfasst, auf der ersten III-V Solarzelle eine organische Schicht (SL) angeordnet ist, **dadurch gekennzeichnet, dass**
- in einem ersten Verfahrensschritt mittels eines Lasers ein erster Graben (GA1) mit einer Breite X und mit einer in dem Epi-Schichtsystem (ES) ausgebildeten Bodenfläche (BO1) erzeugt wird,
- in einem zweiten Verfahrensschritt mittels des Lasers in der Bodenfläche (OS) des ersten Grabens (GA1) ein zweiter Graben (GA2) mit einer Breite Y und mit einer in dem Substrat ausgebildeten Bodenfläche (BO1) erzeugt wird, wobei die Breite Y kleiner als die Breite X ist, so dass sich mit der Ausführung des zweiten Verfahrensschritts eine erste Stufe ausbildet,
- die vorgenannten Verfahrensschritte in der angegebenen Reihenfolge oder in einer Alternative der zweite Verfahrensschritt vor dem ersten Verfahrensschritt ausgeführt wird und der zweite Graben (GA2) mit der Breite Y vor dem ersten Graben (GA1) mit der Breite X erzeugt wird.

2. Verfahren zur Herstellung einer grabenförmigen Struktur (GA) bei einer III-V Mehrfachsolarzelle (MS) nach Anspruch 1, **dadurch gekennzeichnet, dass** in einem dritten Verfahrensschritt entlang der grabenförmigen Struktur (GA) ausgehend von der Oberseite (OS) oder ausgehend von der Unterseite (US) mittels eines Trennprozesses ein Schlitz in den Boden (BO2) des zweiten Grabens erzeugt wird, um das Substrat zu zerteilen.

3. Verfahren zur Herstellung einer grabenförmigen Struktur (GA) bei einer III-V Mehrfachsolarzelle (MS) nach Anspruch 2 oder 3, **dadurch gekennzeichnet, dass** In dem dritten Verfahrensschritt das Substrat (SUB) mittels einer Säge ausgehend von der Unterseite (US) der III-V Mehrfachsolarzelle (MS) zerteilt wird.

4. Verfahren zur Herstellung einer grabenförmigen Struktur (GA) bei einer III-V Mehrfachsolarzelle (MS) nach Anspruch 2 oder 3, **dadurch gekennzeichnet, dass** der dritte Verfahrensschritt unter Verwendung des Lasers ausgehend von der Oberseite (OS) der III-V Mehrfachsolarzelle durchgeführt wird.

5. Verfahren zur Herstellung einer grabenförmigen Struktur (GA) bei einer III-V Mehrfachsolarzelle (MS) nach Anspruch 1 oder Anspruch 2 oder Anspruch 4, **dadurch gekennzeichnet, dass** nach der Ausführung aller laserbasierten Verfahrensschritte ein Nassätzschritt durchgeführt wird.

6. Verfahren zur Herstellung einer grabenförmigen Struktur (GA) bei einer III-V Mehrfachsolarzelle (MS) nach Anspruch 1 oder Anspruch 2 oder Anspruch 4, **dadurch gekennzeichnet, dass** die organische Schicht (SL) erst nach der Ausführung aller laserbasierten Verfahrensschritte und eines Nassätzschritts entfernt wird.

7. Verfahren zur Herstellung eines Grabens (VA) bei einer III-V Mehrfachsolarzelle (MS) nach einem der vorangegangenen Ansprüche, **dadurch gekennzeichnet, dass** das Substrat (SUB) Ge oder GaAs umfasst oder aus Ge oder GaAs besteht.

8. Verfahren zur Herstellung eines Grabens (VA) bei einer III-V Mehrfachsolarzelle (MS) nach einem der vorangegangenen Ansprüche, **dadurch gekennzeichnet, dass** oberhalb der ersten III-V Solarzelle und unterhalb der organischen Schicht (SL) weitere III-V Schichten ausgebildet sind.

9. Verfahren zur Herstellung eines Grabens (VA) bei einer III-V Mehrfachsolarzelle (MS) nach einem der vorangegangenen Ansprüche, **dadurch gekennzeichnet, dass** die organische Schicht (SL) als durchgehende die gesamte Oberseite (OS) der III-V Mehrfachsolarzelle (MS) bedeckende Schicht ausgebildet ist.

10. Verfahren zur Herstellung eines Grabens (VA) bei einer III-V Mehrfachsolarzelle (MS) nach einem der vorangegangenen Ansprüche, **dadurch gekennzeichnet, dass** zwischen der ersten III-V Solarzelle und der organischen Schicht (SL) wenigstens eine III-V Schicht und / oder wenigstens eine dielektrische Schicht (SiO2) ausgebildet ist.

11. Verfahren zur Herstellung eines Grabens (VA) bei einer III-V Mehrfachsolarzelle (MS) nach einem der vorangegangenen Ansprüche, **dadurch gekennzeichnet, dass** zwischen der ersten III-V Solarzelle und der organischen Schicht (SL) eine Antireflexschicht ausgebildet ist.

12. Verfahren zur Herstellung eines Grabens bei einer III-V Mehrfachsolarzelle (MS) nach einem der vorangegangenen Ansprüche, **dadurch gekennzeichnet, dass** auf der Oberseite (OS) der III-V Mehrfachsolarzelle (MS) vor dem ersten Verfahrensschritt In dem Bereich des Grabens zwischen der ersten III-V Solarzelle und der organischen Schicht (SL) eine Metallschicht angeordnet oder keine Metallschicht ausgebildet ist.

13. Verfahren zur Herstellung eines Grabens (VA) bei einer III-V Mehrfachsolarzelle (MS) nach einem der vorangegangen Ansprüche, **dadurch gekennzeichnet, dass** sich der erste Graben (GA1) ausschließlich entlang einer Geraden und /oder einer Krümmung erstreckt und mittels den laserbasierten Verfahrensschritten entlang der Erstreckung des ersten Grabens (GA1) und des zweiten Grabens (GA2) eine erste Stufe (STU1) oder wenigstens zwei Stufen (STU1, STU2) oder genau zwei Stufen (STU1, STU2) ausgebildet werden.

14. Verfahren zur Herstellung einer grabenförmigen Struktur (GA) bei einer III-V Mehrfachsolarzelle (MS) nach einem der vorangegangenen Ansprüche, **dadurch gekennzeichnet, dass** In vorgegebenen Bereichen der dritte Verfahrensschritt nicht ausgeführt wird, so dass der zweite Boden (BO2) erhalten und das Substrat in den vorgegebenen Bereichen nicht zerteilt wird.

## Claims

1. Method of producing a trench-shaped structure (GA) in a III-V multi-junction solar cell (MS) with an upper side (OS) and a lower side (US) and the III-V multi-junction solar cell (MS) comprises a substrate (SUB) arranged at the lower side (US), and the substrate (SUB) is constructed as a semiconductor wafer and has on a front side an epitaxial layer system (ES) with a plurality of III-V layers, wherein the epitaxial layer system (ES) comprises at least one first III-V solar cell formed at the upper side (OS) of the III-V multi-junction solar cell (MS), on which first III-V solar cell an organic layer (SL) is arranged,
**characterised in that**
- in a first method step a first trench (GA1) with a width X and with a base surface (BO1) formed in the epitaxial layer system (ES) is produced by means of a laser,
- in a second method step a second trench (GA2) with a width Y and with a base surface (BO2) formed in the substrate is produced in the base surface (OS) of the first trench (GA1) by means of the laser, wherein the width Y is smaller than the width X so that a first step is formed by the execution of the second method step,
- the aforesaid method steps are executed in the indicated sequence or in an alternative the second method step is executed before the first method step and the second trench (GA2) with the width Y is produced before the first trench (GA1) with the width X.

2. Method of producing a trench-shaped structure (GA) in a III-V multi-junction solar cell (MS) according to claim 1, **characterised in that** in a third method step a slot is produced by means of a separating process in the base (BO2) of the second trench along the trench-shaped structure (GA) starting from the upper side (OS) or starting from the lower side (US) so as to divide the substrate.

3. Method of producing a trench-shaped structure (GA) in a III-V multi-junction solar cell (MS) according to claim 1 or claim 2, **characterised in that** in the third method step the substrate (SUB) is divided by means of a saw starting from the lower side (US) of the III-V multi-junction solar cell (MS).

4. Method of producing a trench-shaped structure (GA) in a III-V multi-junction solar cell (MS) according to claim 2 or 3, **characterised in that** the third method step is performed with use of the laser starting from the upper side (OS) of the III-V multi-junction solar cell.

5. Method of producing a trench-shaped structure (GA) in a III-V multi-junction solar cell (MS) according to claim 1 or claim 2 or claim 4, **characterised in that** a wet-etching step is performed after execution of all laser-based method steps.

6. Method of producing a trench-shaped structure (GA) in a III-V multi-junction solar cell (MS) according to claim 1 or claim 2 or claim 4, **characterised in that** the organic layer (SL) is removed only after execution of the laser-based method steps and a wet-etching step.

7. Method of producing a trench (VA) in a III-V multi-junction solar cell (MS) according to any one of the preceding claims, **characterised in that** the substrate (SUB) comprises Ge or GaAs or consists of Ge or GaAs.

8. Method of producing a trench (VA) in a III-V multi-junction solar cell (MS) according to any one of the preceding claims, **characterised in that** further III-V layers are formed above the first III-V solar cell and below the organic layer (SL).

9. Method of producing a trench (VA) in a III-V multi-junction solar cell (MS) according to any one of the preceding claims, **characterised in that** the organic layer (SL) is formed as a continuous layer covering the entire upper side (OS) of the III-V multi-junction solar cell (MS).

10. Method of producing a trench (VA) in a III-V multi-junction solar cell (MS) according to any one of the preceding claims, **characterised in that** at least one III-V layer and/or at least one dielectric layer (SiO2) is or are formed between the first III-V solar cell and the organic layer.

11. Method of producing a trench (VA) in a III-V multi-junction solar cell (MS) according to any one of the preceding claims, **characterised in that** an anti-reflection layer is formed between the first III-V solar cell and the organic layer.

12. Method of producing a trench in a III-V multi-junction solar cell (MS) according to any one of the preceding claims, **characterised in that** a metal layer is arranged or no metal layer is formed on the upper side (OS) of the III-V multi-junction solar cell (MS) in the region of the trench between the first III-V solar cell and the organic layer (SL) prior to the first method step.

13. Method of producing a trench (VA) in a III-V multi-junction solar cell (MS) according to any one of the preceding claims, **characterised in that** the first trench (GA1) extends exclusively along a straight line and/or a curve and a first step (STU1) or at least two steps (STU1, STU2) or exactly two steps (STU1, STU2) is or are formed along the length of the first trench (GA1) and the second trench (GA2) by means of the laser-based method steps.

14. Method of producing a trench (VA) in a III-V multi-junction solar cell (MS) according to any one of the preceding claims, **characterised in that** the third method step is not executed in predetermined regions so that the second base (BO2) is obtained and the substrate is not divided in the predetermined regions.

## Revendications

1. Procédé de fabrication d'une structure en forme de tranchée (GA) dans une cellule solaire multiple III-V (MS) avec une face supérieure (OS) et une face inférieure (US), et la cellule solaire multiple III-V (MS) comprend un substrat (SUB) disposé sur la face inférieure (US), et le substrat (SUB) est conçu sous la forme de tranche semiconductrice et présente sur une face avant un système de couches épitaxiales (ES) avec plusieurs couches III-V, dans lequel le système de couches épitaxiales (ES) comprend au moins une première cellule solaire III-V conçue sur la face supérieure (OS) de la cellule solaire multiple III-V (MS), et sur la première cellule solaire III-V est disposée une couche organique (SL), **caractérisé en ce que**
- dans une première étape de procédé, est produite à l'aide d'un laser une première tranchée (GA1) avec une largeur X et avec une surface de fond (BO1) conçue dans le système de couches épitaxiales (ES),
- dans une deuxième étape de procédé, est produite à l'aide du laser dans la surface de fond (OS) de la première tranchée (GA1) une seconde tranchée (GA2) avec une largeur Y et avec une surface de fond (BO1) conçue dans le substrat, dans lequel la largeur Y est inférieure à la largeur X de telle sorte qu'un premier niveau soit conçu avec la réalisation de la deuxième étape de procédé,
- les étapes de procédé susmentionnées sont réalisées dans l'ordre indiqué ou en variante la deuxième étape de procédé est réalisée avant la première étape de procédé et la seconde tranchée (GA2) est produite avec la largeur Y avant la première tranchée (GA1) avec la largeur X.

2. Procédé de fabrication d'une structure en forme de tranchée (GA) dans une cellule solaire multiple III-V (MS) selon la revendication 1, **caractérisé en ce que**, dans une troisième étape de procédé, le long de la structure en forme de tranchée (GA) à partir de la face supérieure (OS) ou à partir de la face inférieure (US) à l'aide d'un processus de séparation une fente est produite dans le fond (BO2) de la seconde tranchée pour fendre le substrat.

3. Procédé de fabrication d'une structure en forme de tranchée (GA) dans une cellule solaire multiple III-V (MS) selon la revendication 2 ou 3, **caractérisé en ce que**, dans la troisième étape de procédé, le substrat (SUB) est fendu à l'aide d'une scie à partir de la face inférieure (US) de la cellule solaire multiple III-V (MS).

4. Procédé de fabrication d'une structure en forme de tranchée (GA) dans une cellule solaire multiple III-V (MS) selon la revendication 2 ou 3, **caractérisé en ce que**, la troisième étape de procédé est exécutée en utilisant le laser à partir de la face supérieure (OS) de la cellule solaire multiple III-V.

5. Procédé de fabrication d'une structure en forme de tranchée (GA) dans une cellule solaire multiple III-V (MS) selon la revendication 1 ou la revendication 2 ou la revendication 4, **caractérisé en ce que**, après la réalisation de toutes les étapes de procédé basées sur le laser, une étape de gravure humide est exécutée.

6. Procédé de fabrication d'une structure en forme de tranchée (GA) dans une cellule solaire multiple III-V (MS) selon la revendication 1 ou la revendication 2 ou la revendication 4, **caractérisé en ce que** la couche organique (SL) n'est enlevée qu'après la réalisation de toutes les étapes de procédé basées sur le laser et d'une étape de gravure humide.

7. Procédé de fabrication d'une tranchée (VA) dans une cellule solaire multiple III-V (MS) selon une des revendications précédentes, **caractérisé en ce que** le substrat (SUB) comprend du Ge ou GaAs ou est constitué de Ge ou GaAs.

8. Procédé de fabrication d'une tranchée (VA) dans une cellule solaire multiple III-V (MS) selon une des revendications précédentes, **caractérisé en ce que**, au-dessus de la première cellule solaire III-V et au-dessous de la couche organique (SL) d'autres couches III-V sont conçues.

9. Procédé de fabrication d'une tranchée (VA) dans une cellule solaire multiple III-V (MS) selon une des revendications précédentes, **caractérisé en ce que** la couche organique (SL) est conçue sous la forme d'une couche continue recouvrant toute la face supérieure (OS) de la cellule solaire multiple III-V (MS).

10. Procédé de fabrication d'une tranchée (VA) dans une cellule solaire multiple III-V (MS) selon une des revendications précédentes, **caractérisé en ce que**, entre la première cellule solaire III-V et la couche organique (SL), est conçue au moins une couche III-V et/ou au moins une couche diélectrique (SiO2).

11. Procédé de fabrication d'une tranchée (VA) dans une cellule solaire multiple III-V (MS) selon une des revendications précédentes, **caractérisé en ce que**, entre la première cellule solaire III-V et la couche organique (SL), est conçue une couche antireflet.

12. Procédé de fabrication d'une tranchée dans une cellule solaire multiple III-V (MS) selon une des revendications précédentes, **caractérisé en ce que**, sur la face supérieure (OS) de la cellule solaire multiple III-V (MS), avant la première étape de procédé, dans la zone de la tranchée entre la première cellule solaire III-V et la couche organique (SL), une couche métallique est disposée ou bien aucune couche métallique n'est conçue.

13. Procédé de fabrication d'une tranchée (VA) dans une cellule solaire multiple III-V (MS) selon une des revendications précédentes, **caractérisé en ce que** la première tranchée (GA1) s'étend exclusivement le long d'une droite et/ou d'une courbure et, à l'aide de l'étape de procédée basée sur le laser, le long de l'extension de la première tranchée (GA1) et de la seconde tranchée (GA2), un premier niveau (STU1) ou au moins deux niveaux (STU1, STU2) ou exactement deux niveaux (STU1, STU2) sont conçus.

14. Procédé de fabrication d'une structure en forme de tranchée (GA) dans une cellule solaire multiple III-V (MS) selon une des revendications précédentes, **caractérisé en ce que**, dans des zones prédéfinies, la troisième étape de procédé n'est pas exécutée de telle sorte que le second fond (BO2) soit conservé et le substrat ne soit pas fendu dans les zones prédéfinies.
